(19) Europäisches Patentamt / European Patent Office / Office européen des brevets

(11) EP 3 044 601 B1

(12) FASCICULE DE BREVET EUROPEEN

(45) Date de publication et mention de la délivrance du brevet:
11.12.2019 Bulletin 2019/50

(21) Numéro de dépôt: 14766148.2

(22) Date de dépôt: 10.09.2014

(51) Int Cl.:
G01R 31/36 $^{(2019.01)}$   B60L 3/00 $^{(2019.01)}$

(86) Numéro de dépôt international:
PCT/EP2014/069327

(87) Numéro de publication internationale:
WO 2015/036453 (19.03.2015 Gazette 2015/11)

(54) **PROCEDE, DISPOSITIF ET SYSTEME D'ESTIMATION DE L'ETAT DE CHARGE D'UNE BATTERIE**

VERFAHREN, VORRICHTUNG UND SYSTEM ZUR BESTIMMUNG DES LADEZUSTANDS EINES AKKUMULATORS

METHOD, DEVICE AND SYSTEM FOR ESTIMATING THE STATE OF CHARGE OF A BATTERY

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: 11.09.2013 FR 1358743

(43) Date de publication de la demande:
20.07.2016 Bulletin 2016/29

(73) Titulaire: Commissariat à l'Énergie Atomique et aux Énergies Alternatives
75015 Paris (FR)
(72) Inventeurs:
• BILETSKA, Krystyna
F-91400 Orsay (FR)
• SUARD, Frédéric
F-78000 Versailles (FR)
• MONTARU, Maxime
F-15170 Joursac (FR)

(74) Mandataire: Priori, Enrico et al
Marks & Clerk France
Immeuble "Visium"
22, avenue Aristide Briand
94117 Arcueil Cedex (FR)

(56) Documents cités:
DE-A1- 10 328 721    DE-C1- 19 960 761
US-A1- 2003 030 442    US-A1- 2005 088 145
US-A1- 2010 090 651    US-A1- 2013 013 235

**Description**

L'invention porte sur un procédé, sur un dispositif et sur un système d'estimation de l'état de charge d'une batterie, et notamment (mais pas exclusivement) d'une batterie d'un véhicule électrique ou hybride. L'invention porte également sur un dispositif d'estimation de modèles de régression coopérant avec un tel dispositif d'estimation de l'état de charge d'une batterie dans le cadre d'un tel système.

La quantité de la charge stockée dans une batterie est généralement caractérisée par son état de charge, indiqué le plus souvent par le sigle SoC (de l'anglais « state of charge »), qui est défini comme le rapport de la capacité disponible sur la capacité maximale possible de la batterie.

La connaissance du SoC dans une batterie à un moment donné est primordiale pour tous les systèmes qui sont alimentés par une batterie, car leur autonomie restante en dépend. Malheureusement, il est impossible de mesurer le SoC directement. Il est possible d'utiliser certaines grandeurs physiques mesurables pour lesquelles un lien avec le SoC est établi. Mais la mesure de telles grandeurs est régie par des nombreuses contraintes liées à l'environnement de la batterie et aux conditions de son utilisation. Par exemple, il est possible d'utiliser la tension à vide ; cependant, les conditions de mesure de cette tension restent limitées aux périodes pendant laquelle la batterie n'est pas utilisé. Il est également possible d'utiliser l'impédance de la batterie ; cependant, cette grandeur est fortement influencée par les conditions expérimentales comme la température et le courant. De ce fait, l'état de charge d'une batterie ne peut qu'être estimé en cours d'utilisation à l'aide d'un modèle approprié.

Cette estimation est sensiblement compliquée par le fait que l'état de charge d'une batterie dépend d'une multitude de paramètres : les conditions de son utilisation, c'est-à-dire son régime de charge ou décharge, la température externe, des caractéristiques intrinsèques de la batterie, etc. Le calcul du SoC dépend en effet de la capacité maximale $C_{max}$ de la batterie, qui peut être considérablement réduite si la température externe est basse. Par exemple, la capacité maximale à un instant donné peut correspondre à 80% de la capacité maximale mesurée dans les conditions plus favorables. De plus, elle diminue au fur et à mesure que la batterie vieillit et permet d'établir un critère de vieillissement appelé état de vie (SoH).

En raison de l'importance technique et économique du problème, de très nombreuses méthodes d'estimation de l'état de charge d'une batterie ont été proposées. Plusieurs de ces méthodes sont décrites dans l'article de S. Piller, M. Perrin et A. Jossen « Methods for state-of-charge détermination and their applications », Journal of Power Sources 96 (2001) 113 - 120.

Les méthodes dites de « calcul direct » reposent sur des abaques qui mettent en correspondance de façon biunivoque l'état de charge d'une batterie avec une autre grandeur physique caractéristique de la batterie, le plus souvent une tension U mesurée aux bornes de la batterie, et notamment la tension à vide $U_0$. Voir par exemple le document US 4,677,363. Malheureusement, une relation « SoC = f(U) » - où $U$ est la tension mesurée aux bornes de la batterie - n'est pas strictement biunivoque pour toutes les types de batteries, notamment, celles à Li-ions. D'autres grandeurs physiques telles que la tension à vide $U_0$, les propriétés physiques de l'électrolyte et l'impédance électrochimique Z ont été proposées pour estimer le SoC. La relation SoC = f($U_0$), en particulier, est fiable mais peu commode car la tension à vide ne peut être mesurée que lorsqu'une batterie se trouve dans un état de repos depuis un certain temps et dans des conditions spécifiques de température. Les propriétés physiques de l'électrolyte ne peuvent être mesurées que lorsque ce dernier est liquide et, par conséquent, ne peuvent pas être exploitées pour tout type de composition électrochimique des batteries. La relation SoC = f(Z) n'est pas strictement biunivoque pour tout type de batterie et varie beaucoup en fonction de la température de la batterie et de son régime de charge/décharge. En outre, construire des abaques pour toutes les températures, tous les états de vieillissement et tous les régimes de décharge/charge d'une batterie est une tâche très laborieuse nécessitant du matériel spécifique et coûteux. De plus ces méthodes ne permettent pas d'intégrer directement la dispersion dans les comportements des batteries de même composition électrochimique. L'imprécision des mesures et la faible représentation de la diversité des comportements d'une batterie que proposent des abaques ne permettent pas d'appliquer la technique du calcul direct en temps réel telle quelle, mais nécessitent des procédures d'étalonnage pouvant amener un surcoût important.

Le document US 2010/0090651 décrit un procédé d'estimation de l'état de charge d'une batterie comportant deux étapes :

- d'abord, une étape d'estimation de la tension à vide $U_0$ par interpolation linéaire de mesures de tension et de courant ;
- puis, une étape de détermination de l'état de charge à partir de la valeur ainsi estimée de $U_0$ au moyen d'un abaque.

Pour mettre en œuvre la première étape, deux modèles de régression différents sont utilisés selon que la batterie soit en condition de charge ou de décharge.

Ce procédé présente les inconvénients précités des méthodes de calcul direct, sauf en ce qu'il ne nécessite pas une mesure directe de $U_0$.

L'estimation du SoC basée sur des modèles physiques est la plus répandue. Il s'agit des modèles qui reposent sur des variables telles qu'un courant, une tension, une température interne, une tension à vide, une température externe, une impédance, etc. La façon la plus simple et la plus connue d'estimation du SoC est la « coulométrie », qui consiste à calculer la quantité de charge $C_{F/E}$ fournie par / extraite d'une batterie relative à la capacité maximale $C_{max}$ de la batterie. La quantité de charge $C_{F/E}$ est estimée en intégrant le courant I(t) en cours d'utilisation de la batterie. L'estimateur coulométrique du SoC est exprimé comme suit :

$$SoC(t) = SoC_0 + \frac{C_{F/E}}{C_{max}} = SoC_0 + \frac{1}{C_{max}} \int_{t_0}^{t} \eta \cdot I(\tau) d\tau \qquad (1)$$

où $SoC_0$ est un état de charge initiale, supposé connu (par exemple, un état de charge complète ou de décharge complète), $[t_0, t]$ est une période d'utilisation de la batterie et $\eta$ le rendement Faradique (rapport entre la charge qui peut être stockée dans la batterie et la charge qui peut en être extraite). Voir par exemple l'article de Kong Soon Ng et al. « Enhanced coulomb counting method for estimating state-of-charge and state-of-health of lithium-ion batteries », Applied Energy 86 2009) 1506 - 1511.

Cette méthode présente un certain nombre d'inconvénients :

- le capteur de courant peut être imprécis et, comme le courant mesurée est intégré, les erreurs de mesure se cumulent ;
- la connaissance de la capacité maximale est difficile dans le cadre de l'application et peut donc être très approximative ;
- le phénomène d'autodécharge n'est pas pris en compte ;
- le rendement Faradique est également peu connu en temps réel.

Le modèle coulométrique d'estimation du SoC peut être améliorée en la combinant avec des modèles d'autres grandeurs physiques mesurables au moyen de techniques de fusion de données telles que filtrage de Kalman. Cette technique nécessite la construction d'un modèle de la batterie sous forme d'un circuit équivalent qui dépend de la composition électrochimique de la batterie, et n'est donc pas générique.

D'autres méthodes encore permettent d'estimer le *SoC* à partir de modèles de la cinétique des réactions chimiques et du phénomène de diffusion, qui sont propres à chaque type de composition électrochimique de la batterie. Le principal inconvénient de ces méthodes est leur manque de généralité.

Enfin, de nombreuses autres méthodes d'estimation du SoC utilisent des techniques d'apprentissage statistiques pour déterminer de manière automatique des coefficients d'un modèle physique, semi-physique voire purement mathématique (approche du type « boite noire »).

L'article de T. Hansen et Chia-Jiu Wang « Support vector based state of charge estimator », Journal of Power Sources 141 (2005), pages 351 - 358 et le brevet US 7,197,487 décrivent une méthode d'estimation du SoC à partir d'un modèle de régression à noyaux avec un noyau polynomial dont les coefficients sont estimés par la méthode de Régression à vecteurs support (SVR, de l'anglais « Support Vector Regression »). La demande de brevet US 2010/0324848 décrit l'utilisation d'un réseau de neurones - et de plusieurs techniques mathématiques d'estimation des coefficients de ce réseau - pour estimer le SoC d'une batterie à partir de mesures instantanées de tension, courant et température, et à partir des dérivées première et seconde de la tension.

Ces méthodes, basées sur l'apprentissage statistique, sont potentiellement très générales, car elles utilisent des modèles qui ne sont basés sur aucune hypothèse relative à la composition, la structure ou le fonctionnement de la batterie. De plus ces modèles sont souples car peuvent utiliser un nombre variable de variables d'entrée et ne dépendent pas de la nature de ces dernières. Cependant, les présents inventeurs se sont rendus compte que cette grande généralité est difficilement atteinte en pratique. En effet, la généralité d'un modèle dépend de manière critique de la qualité de sa base d'apprentissage, c'est-à-dire de la base de données utilisée pour l'apprentissage des coefficients du modèle d'estimation du SoC. Cette base doit être suffisamment exhaustive sans être redondante, et sans que sa taille ne devienne trop importante.

L'invention vise à procurer un procédé et un système d'estimation de l'état de charge d'une batterie ne présentant pas les inconvénients précités de l'art antérieur. Avantageusement, un tel procédé et un tel système présentent un niveau de généralité élevé (c'est-à-dire qu'ils peuvent être appliqués à des batteries de types différents et/ou dans des conditions d'utilisation différentes) et conviennent à des applications en temps réel au moyen de capteurs embarqués.

Un objet de l'invention est donc un procédé d'estimation de l'état de charge d'une batterie selon la revendication 1 comprenant les étapes suivantes :

a) acquérir au moins une série temporelle de mesures de tension aux bornes de ladite batterie, ainsi qu'au moins une autre série temporelle de mesures d'un autre paramètre physique de ladite batterie ou de son environnement ;

b) en fonction desdites mesures, déterminer un régime de fonctionnement de ladite batterie ;

c) en fonction dudit régime de fonctionnement, choisir un modèle de régression non-linéaire parmi un ensemble prédéfini de tels modèles ; et

d) estimer l'état de charge de ladite batterie par application « directe » dudit modèle de régression non linéaire à ladite série temporelle de mesures de tension et à ladite ou à au moins une dite autre série temporelle de mesures.

Ledit régime de fonctionnement peut notamment être défini par au moins un paramètre choisi parmi : un état de charge de la batterie, le fait qu'elle soit en cours de chargement ou de déchargement, une vitesse de chargement ou une température.

Plus généralement, ledit régime de fonctionnement peut être défini par au moins un paramètre choisi parmi : un état de charge de la batterie, le fait qu'elle soit en cours de chargement ou de déchargement, une vitesse de chargement ou de déchargement, une température ambiante ou interne, une moyenne de valeurs de ladite série temporelle de mesures de tension, une impédance de la batterie ou une mesure de son état de santé.

Selon des modes de réalisation particuliers d'un tel procédé :

-    Ledit ou les autres dits paramètres physiques peuvent être choisis parmi : un courant fourni ou absorbé par la batterie, une température interne de la batterie, une température ambiante.
-    Ladite étape a) peut comprendre au moins l'acquisition d'une série temporelle de mesures de tension aux bornes de ladite batterie et d'une série temporelle de mesures de courant fourni ou absorbé par la batterie ; et ladite étape b) peut comprendre la détermination dudit régime de fonctionnement de ladite batterie - notamment lorsque ce dernier est défini par une plage d'états de charge - à partir d'au moins une valeur de tension et une valeur de courant issues desdites séries temporelles de mesures.
-    Ladite étape b) peut comprendre la détermination dudit régime de fonctionnement de ladite batterie - notamment lorsque ce dernier est défini par une plage d'états de charge - à partir d'une valeur moyenne de tension à ses bornes et d'une valeur moyenne de courant absorbé ou fourni par la batterie au moyen d'un tableau ou fonction de correspondance.

-    Ladite étape c) peut comprendre le choix d'un modèle, également en fonction dudit ou d'un dit autre paramètre physique ou d'une information d'état de santé de ladite batterie.
-    Le procédé peut comprendre une opération de filtrage passe-bas ou lissage de ladite ou d'au moins une dite série temporelle de mesures préalablement à ladite étape d).
-    Ledit ensemble prédéfini de modèles peut comprendre une pluralité de modèles dont au moins un choisi parmi un modèle de régression à noyaux, un modèle de régression à vecteurs de support et une machine à vecteurs pertinents.
-    Le procédé peut comprendre également les étapes suivantes : e) déterminer si lesdites séries temporelles de mesures correspondent à des conditions d'utilisation qui n'ont pas été prises en compte lors de la construction des modèles de régression dudit ensemble ; et f) dans l'affirmative, stocker ladite ou lesdites séries temporelles de mesures dans une base de données. Une condition d'utilisation peut être définie par un ou plusieurs paramètres de la batterie ou de son environnement de telle sorte qu'un régime de fonctionnement - utilisé pour la sélection du modèle de régression non linéaire - correspond à une collection de conditions d'utilisation. Par exemple, une condition d'utilisation peut être définie par un ou plusieurs paramètres choisis parmi une moyenne de valeurs de ladite série temporelle de mesures de tension, le fait que la batterie soit en cours de chargement ou déchargement, un courant de chargement ou déchargement de la batterie ou une température externe.
-    Ladite étape f) peut comprendre également la détermination d'une information relative à un état de charge de ladite batterie et l'association de ladite information à ladite ou à chaque dite série temporelle de mesures, le procédé comprenant également une opération d'exclusion de ladite base de données d'au moins une série temporelle de mesures sur la base d'une comparaison entre l'information d'état de charge qui lui est associée et une information d'état de charge de la batterie déterminée ultérieurement.
-    Le procédé peut comprendre également l'étape suivante : g) construire les modèles de régression dudit ensemble par apprentissage à partir au moins d'une pluralité de séries temporelles de mesures de tension aux bornes de ladite batterie et d'au moins une autre série temporelle de mesures d'un autre paramètre physique de ladite batterie ou de son environnement, et de valeurs de référence correspondants de l'état de charge de ladite batterie.
-    Le procédé peut comporter également l'étape suivante : h) reconstruire par apprentissage lesdits ou au moins un dit modèle de régression, ou construire par apprentissage un nouveau modèle de régression dudit ensemble, en tenant compte de la ou des séries temporelles stockées dans ladite base de données lors de ladite étape f).
-    Ladite étape g) et/ou ladite étape h) peuvent comprendre des opérations préalables de filtrage passe-bas ou lissage et de sous-échantillonnage desdites séries temporelles de mesures.
-    Ladite étape g) et/ou ladite étape h) peuvent comprendre le calcul en temps différé d'estimateurs coulométriques de la charge de ladite batterie à partir de séries temporelles de mesures de courant acquises lors de ladite étape a), et l'utilisation desdits estimateurs coulométriques en tant que valeurs de référence de l'état de charge de ladite batterie pour la construction ou reconstruction par apprentissage desdits modèles de régression.

- Ladite batterie peut être intégrée à un dispositif consommateur d'énergie, et lesdites étapes a) à d) ou a) à f) peuvent être mises en œuvre en temps réel par un dispositif d'estimation d'état de charge également intégré audit dispositif consommateur d'énergie.
- Ladite étape g) ou lesdites étapes g) et h) peuvent être mises en œuvre en temps différé par un dispositif d'apprentissage de régression non intégré audit dispositif consommateur d'énergie.

Un autre objet de l'invention est un dispositif d'estimation d'état de charge d'une batterie selon la revendication 16 comportant: au moins un capteur de tension, pour mesurer une tension aux bornes de ladite batterie ; au moins un autre capteur, pour mesurer un autre paramètre physique de ladite batterie ou de son environnement ; une mémoire pour stocker un ensemble de modèles de régression de l'état de charge de ladite batterie ; et un processeur programmé ou configuré pour mettre en œuvre les étapes a) à d) ou a) à f) d'un procédé tel que mentionné ci-dessus en coopérant avec lesdits capteurs et ladite mémoire.

Encore un autre objet de l'invention est un dispositif d'apprentissage de modèles de régression selon la revendication 17.

Encore un autre objet de l'invention est un système d'estimation de l'état de charge d'une batterie comprenant un tel dispositif d'estimation d'état de charge, un tel dispositif d'apprentissage de modèles de régression et un système de transmission de données reliant lesdits dispositifs.

D'autres caractéristiques, détails et avantages de l'invention ressortiront à la lecture de la description faite en référence aux dessins annexés donnés à titre d'exemple et qui représentent, respectivement :

- La figure 1, un schéma fonctionnel d'un système d'estimation de l'état de charge d'une batterie selon un mode de réalisation de l'invention ;
- La figure 2, un ordinogramme d'un procédé d'estimation de l'état de charge d'une batterie selon un mode de réalisation de l'invention ;
- Les figures 3A et 3B, des graphiques illustrant les erreurs d'approximation induits par le filtrage des données utilisées pour l'estimation de l'état de charge d'une batterie selon un mode de réalisation de l'invention ;
- La figure 4, un graphique illustrant plus en détail une étape de détermination d'un régime de fonctionnement de la batterie, déterminant le choix d'un modèle de régression dans le cadre du procédé de la figure 2 ;
- La figure 5, un ordinogramme illustrant plus en détail une opération de sélection des mesures à sauvegarder dans le cadre du procédé de la figure 2 ;
- La figure 6, des graphiques illustrant des séries temporelles de mesures de courant, tension et température interne d'une batterie, ainsi que des estimations d'état de charge de ladite batterie obtenues à partir de ces mesures et au moyen du procédé de la figure 2 ; et
- Les figures 7A et 7B, des ordinogrammes illustrant plus en détail une opération de construction d'un modèle de régression par apprentissage statistique avec validation croisée dans le cadre du procédé de la figure 2.

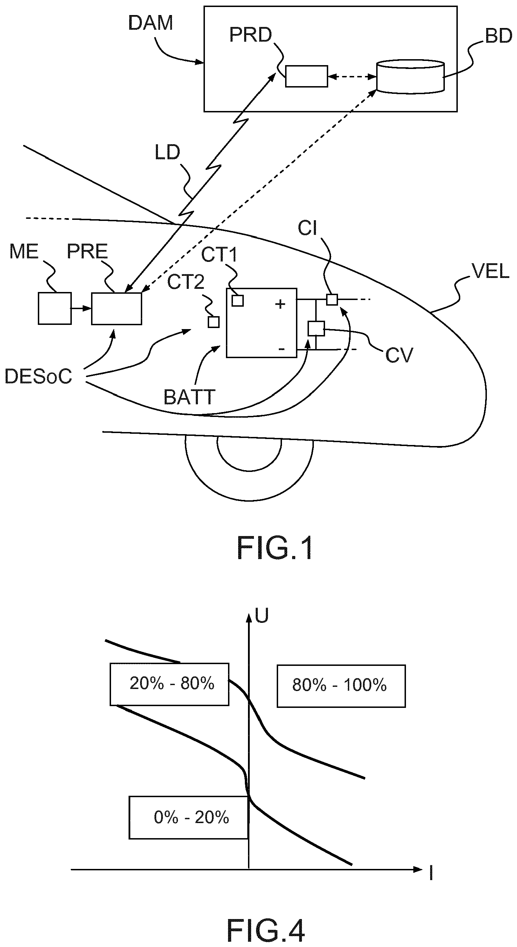

La figure 1 représente une batterie électrique BATT embarquée dans un véhicule terrestre électrique ou hybride VEL et connectée à un dispositif d'estimation d'état de charge DESoC selon un mode de réalisation de l'invention. Ce dispositif, également embarqué, comprend un processeur PRE et une pluralité de capteurs, et notamment : un capteur de tension CV pour mesurer la tension aux bornes de la batterie ; un capteur de courant CI pour mesurer un courant fourni (ou absorbé) par la batterie, un premier capteur de température CT1 pour mesurer une température interne de la batterie et un deuxième capteur de température CT2 pour mesurer une température ambiante à l'extérieur de la température. D'autres capteurs peuvent également être présents, notamment d'autres capteurs de température pour mesurer des températures à différents endroits de la batterie ou de son environnement. Le dispositif DESoC comprend également une mémoire ME dans laquelle sont stockés les coefficients qui définissent plusieurs modèles de régression de l'état de charge de la batterie, ainsi que des informations permettant de définir un régime de fonctionnement pour lequel chaque modèle est approprié. Les signaux générés par les capteurs sont adressés au processeur PRE qui les traite d'une façon qui sera décrite en détail plus loin et les utilise pour estimer l'état de charge de la batterie, à l'aide des informations stockées dans la mémoire ME.

Le processeur embarqué PRE du dispositif DESoC communique, à travers un système de communication réalisant une liaison de données LD, avec un dispositif d'apprentissage de modèles DAM, qui n'est pas embarqué dans le véhicule. La liaison de données peut être filaire - ce qui implique une proximité entre le véhicule et le dispositif DAM ou sans fils, par exemple exploitant un réseau de télécommunications. La communication n'a pas à être continue ; elle peut au contraire être intermittente, des courtes phases d'échange de données étant espacées par des plus longues périodes pendant lesquelles le dispositif DESoC fonctionne de manière autonome.

Le dispositif DAM comprend à son tour un processeur PRD et une base de données BD.

Comme cela sera expliqué en détail plus loin, la base de données BD est approvisionnée en données à stocker par le dispositif DESoC (qui, en cas de communication intermittente, les avait stockées provisoirement dans une mémoire auxiliaire non représentée sur la figure) ; le processeur distant PRD y accède en lecture pour générer des modèles d'état de charge à partir des données qui y sont stockées, puis lesdits modèles sont communiqués au dispositif d'estimation DESoC qui les stocke dans sa mémoire ME.

Dans le mode de réalisation de la figure 1, la base de données BD est colocalisée avec le dispositif d'apprentissage DAM, et le dispositif d'estimation DESoC y accède par l'intermédiaire de la liaison de données LD, mais cela n'est pas essentiel.

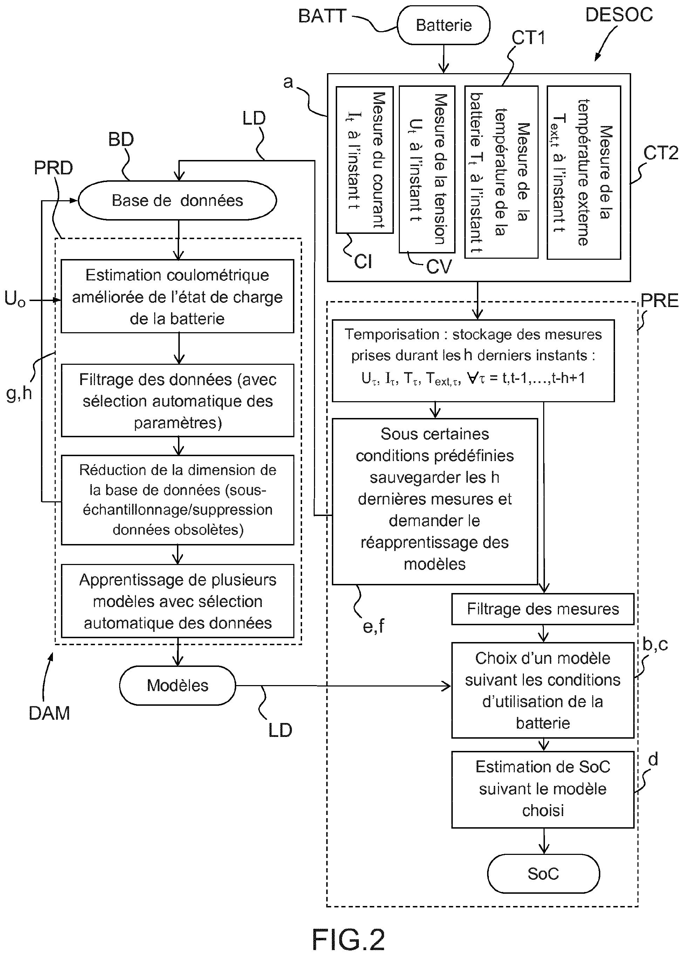

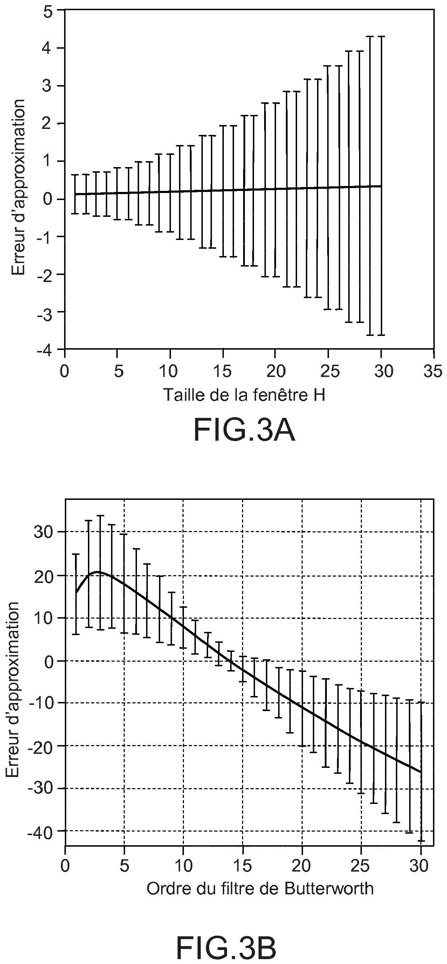

La figure 2 illustre, d'une manière générale, un procédé d'estimation de l'état de charge d'une batterie selon un mode de réalisation de l'invention, pouvant être mis en œuvre au moyen du système de la figure 1 (dispositif d'estimation DESoC, dispositif d'apprentissage DAM, liaison de données LD et base de données BD). Les différentes étapes de ce procédé seront décrites en détail plus loin, à l'aide des figures 3A à 7B.

Comme le montre la figure 2, la première étape (a) du procédé comprend l'acquisition, par les capteurs embarqués CI, CV, CT1 et CT2, de différentes séries temporelles de mesures relatives au fonctionnement de la batterie : mesures de tension $U_\tau$, de courant $I_\tau$, de température interne $T_{int,\tau}$, de température externe $T_{int,\tau}$ (l'indice $\tau$ représente l'instant d'acquisition de la mesure). Toutes ces mesures peuvent ne pas être nécessaires et d'autres mesures peuvent être ajoutées à la liste fournie à titre d'exemple. En général, au moins les mesures de tension $U_\tau$ seront nécessaires. Par contre, il peut être avantageux de ne pas utiliser le courant $I_\tau$ pour l'estimation de l'état de charge car les capteurs embarqués de courant sont sujets à des erreurs de mesure importantes. La fréquence d'acquisition des mesures peut être élevée, de l'ordre de 10 mesures par seconde ou supérieure, ou plus faible, de l'ordre d'une mesure par seconde ou moins, en fonction de l'application spécifique considérée.

Les *h* dernières acquisition de chaque dite mesure sont stockées pour être utilisées pour l'estimation de l'état de charge au temps t-*h*. La valeur du paramètre *h* peut être typiquement comprise entre 1 et 50, pour des cadences d'acquisitions comprises entre 0,1 Hz et 10 Hz ; elle peut être choisie par essais.

Les séries temporelles de mesures sont ensuite de-bruitées par un filtre passe-bas ou une technique de lissage. Plusieurs techniques de filtrage ou lissage peuvent être adoptées. A titre d'exemple on peut citer l'utilisation d'un filtre médian ou d'un filtre numérique de Butterworth. Le filtre médian consiste à remplacer chaque élément $x_\tau$ d'une série temporelle par la valeur médiane des éléments contenus dans une fenêtre glissante de longueur (H+1), H étant un paramètre qui peut notamment être égal à la fenêtre d'acquisition « h » : $x_{\tau-H/2}$... $x_{\tau+H/2}$ (H est considéré paire). Comme illustré sur la figure 3A, plus H est grand, moindre est la précision d'approximation du signal initial. Le filtre de Butterworth est connu en soi ; il s'agit ici d'un filtre numérique, exprimé par une équation aux différences. La figure 3B montre qu'il existe un ordre optimal pour ce filtre (ici, 14) minimisant l'erreur d'approximation.

L'étape (b) du procédé consiste à déterminer un régime de fonctionnement de la batterie, notamment caractérisé par une plage d'états de charge. Par exemple, on peut identifier trois régimes de fonctionnement : batterie presque déchargée - SoC compris entre 0% et 20% ; batterie partiellement chargée - SoC compris entre 20% et 80% ; batterie chargée - SoC compris entre 80% et 100%. La détermination du régime de fonctionnement se base donc sur une estimation approximative - voire grossière - de l'état de charge. Cette estimation peut être obtenue par « calcul direct », par exemple à partir de la tension et du courant moyens au cours de l'intervalle d'acquisition. Dans un autre mode de réalisation, moins performant, l'estimation peut se baser uniquement sur des mesures de tension. Peu importe que cette méthode soit peu précise, car le but est seulement d'identifier le régime de fonctionnement. La figure 4 illustre une décomposition du plan V-I en trois régions correspondant aux régimes de fonctionnement [0 - 20%], [20% - 80%] et [80% - 100%].

D'autres paramètres peuvent également être pris en compte - en complément, voire en remplacement de la plage de SoC estimée à partir de la tension mesurée - pour la détermination du régime de fonctionnement : le fait que la batterie soit en cours de chargement ou de déchargement, la vitesse de chargement/déchargement, la température ambiante ou interne, une moyenne de valeurs de ladite série temporelle de mesures de tension, le fait que la batterie soit en cours de chargement ou de déchargement, une vitesse de chargement ou de déchargement, une impédance de la batterie ou une mesure de son état de santé. L'état de santé (SoH, pour « state of health », en anglais) est une mesure des performances d'une batterie par rapport à son état nominal ; il peut s'agir par exemple d'un rapport entre la capacité de la batterie et sa capacité nominale, lorsqu'elle est neuve.

Lors de l'étape (c), un modèle de régression - parmi ceux qui sont stockés dans la mémoire ME du dispositif d'estimation DESoC - est choisi en fonction du régime de fonctionnement actuel de la batterie. En effet, les présents inventeurs se sont rendus compte qu'il est difficile en pratique de créer, par apprentissage statistique, un seul modèle de régression permettant une estimation fiable de l'état de charge d'une batterie. Pour qu'une méthode d'apprentissage produise une estimation de bonne qualité la base d'apprentissage doit être exhaustive, c'est-à-dire refléter toute la diversité des comportements d'une batterie, et par conséquent sa taille doit être très importante. Or, les méthodes connues d'apprentissage statistique ont des limites et ne fonctionnent plus lorsque la base d'apprentissage devient trop grande. Conformément à l'invention, il est donc proposé de créer une pluralité de modèles destinés à être utilisés seulement pour des régimes de fonctionnement respectifs. Chaque modèle est créé par apprentissage à partir d'un sous-ensemble seulement de la base de données d'apprentissage effectivement disponible. En même temps, comme chaque modèle n'est destiné à servir que pour un régime de fonctionnement, cette réduction de la taille de la base d'apprentissage utilisée n'en compromet pas l'exhaustivité. Cette démarche permet, d'une part, d'augmenter la quantité d'information utile contenue dans la base d'apprentissage et, d'autre part, d'obtenir un modèle d'estimation beaucoup plus précis que dans le cas des techniques connues de l'art antérieur.

Comme cela sera expliqué plus loin, l'apprentissage des modèles se fait à partir de séries temporelles ou ensembles de mesures stockées dans la base de données BD.

Ensuite, lors de l'étape (d) du procédé, le modèle choisi est utilisé pour estimer l'état de charge SoC à partir des séries temporelles de mesure filtrées.

D'une manière générale, chacun des modèles stockés dans la mémoire ME peut s'écrire sous la forme :

$$SoC_t = f_\lambda(\mathbf{x_t}, \mathbf{w}) \tag{2}$$

où $SoC_t$ est la valeur instantanée, au temps « t », de l'état de charge que l'on cherche à estimer, $f_\lambda$ est une fonction, généralement non linéaire, dépendant du vecteur de paramètres $\lambda$, $\mathbf{x_t}$ est un vecteur de « variables explicatives », c'est-à-dire de mesures (de tension, courant, température interne et/ou externe...) à l'instant « t » - après filtrage - $\mathbf{w}$ un vecteur de *coefficients de régression,* déterminé par apprentissage statistiques. Les modèles associés aux différents régimes de fonctionnement de la batterie se distinguent par leurs vecteurs de coefficients de régression, leurs paramètres $\lambda$, voire par la forme de leurs fonctions $f_\lambda$. Des grandeurs « dérivées » telles que la vitesse de changement du courant $\frac{dI_t}{dt}$, la vitesse de changement de la tension $\frac{dU_t}{dt}$ et/ou l'impédance électrique $Z_t = U_t/I_t$ peuvent éventuellement faire partie des variables explicatives du modèle d'estimation de *SoC.*

Un aspect important de l'invention est le fait que l'ensemble de modèles de régression peut être enrichi et actualisé progressivement, en réapprenant les modèles existants à l'aide des mesures nouvellement acquises, en ajoutant de nouveaux modèles et/ou en supprimant des modèles qui sont jugés dépassés.

Dans une étape (e), le processeur embarqué PRE détermine si la ou les séries temporelles de mesures qui viennent d'être acquises correspondent à des conditions d'utilisation nouvelles, qui n'ont pas été enregistrées dans la base de données BD et qui n'ont donc pas été prises en compte lors de la construction des modèles de régression stockés dans la mémoire ME. La notion de « conditions d'utilisation » doit être distinguée de celle de « régime de fonctionnement » qui gouverne le choix du modèle. Par exemple, deux séries temporelles caractérisées par des états de charge similaires mais à des températures internes différentes correspondent à un même régime de fonctionnement (et donc à un même modèle de régression) mais à des conditions d'utilisations différentes. Par contre, un régime de fonctionnement différent implique nécessairement des conditions d'utilisations différentes.

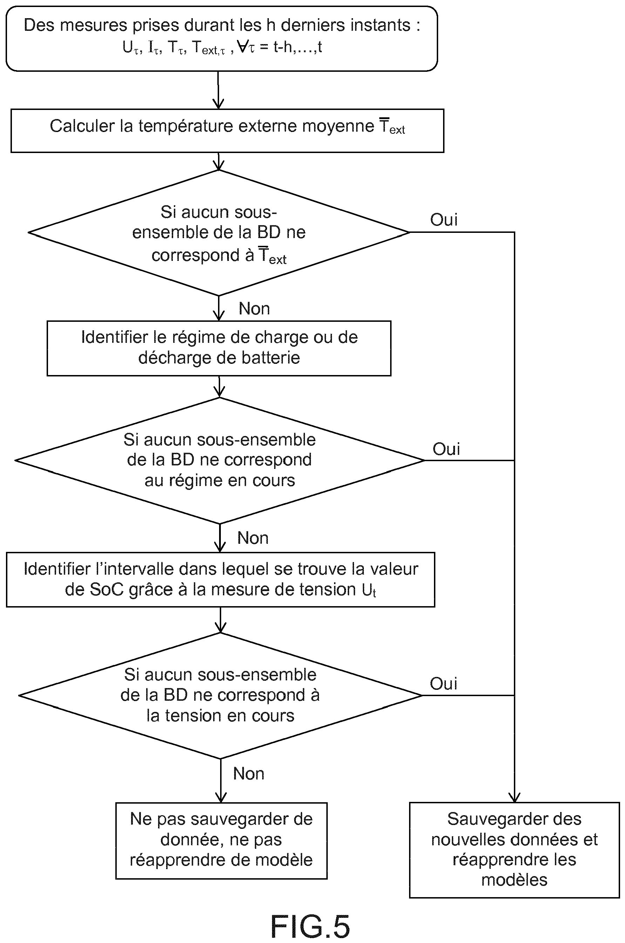

Un mode de réalisation possible de ladite étape (e) est illustré plus en détail sur la figure 5.

Premièrement on vérifie si la température externe moyenne $\overline{T}_{ext}$ mesurée sur la fenêtre d'acquisition h, correspond à une valeur déjà enregistrée dans la base de données. Si ce n'est pas le cas, les séries temporelles de mesures qui viennent d'être acquises sont considérées comme « non redondantes » (correspondant à des conditions d'utilisation nouvelles) et seront sauvegardées lors d'une étape (f) ultérieure. Sinon, le processus de sélection continue.

Dans un deuxième temps on identifie le régime de charge ou de décharge de la batterie (c'est-à-dire qu'on détermine si elle est en cours de chargement ou déchargement, et à quelle vitesse, exprimée par l'intensité de courant électrique absorbée ou fournie par la batterie). Si aucune des séries temporelles de mesures stockées dans la base - et correspondant à la température externe moyenne $\overline{T}_{ext}$ - ne correspond à un tel régime de charge/décharge, les séries temporelles de mesures qui viennent d'être acquises sont considérées comme « non redondantes » ; sinon, le processus de sélection continue.

Ensuite, à partir de la tension moyenne, on détermine l'intervalle d'état de charge dans lequel se trouve la batterie, comme cela a été fait lors de l'étape (b) précitée. Encore une fois, si aucune des séries temporelles de mesures stockées dans la base - et correspondant à la température externe moyenne $\overline{T}_{ext}$, ainsi qu'au régime de charge/décharge identifié en précédence - correspond à un tel intervalle de SoC, les séries temporelles de mesures qui viennent d'être acquises sont considérées comme « non redondantes ». Sinon, elles sont considérées comme « redondantes », et ne sont alors pas stockées. En tout cas, le processus s'arrête à ce stade. D'autres modes de réalisation sont envisageables, prenant en compte d'autres paramètres définissant les conditions d'utilisation.

On remarquera que la mise en œuvre de l'étape (e) implique que la base de données BD ne contienne pas uniquement des séries temporelles de mesures, mais également des indications relatives aux conditions d'utilisation dans lesquelles elles ont été acquises.

Si, et seulement si, les séries temporelles de mesures nouvellement acquises correspondent à des conditions d'utilisation nouvelles, elles seront stockées dans la base de données - étape (f) - afin d'être utilisées, conjointement aux mesures qui étaient déjà stockées dans la base de données, pour « réapprendre » le modèle de régression associé au régime de fonctionnement correspondant. L'idée est que l'apprentissage de chaque modèle doit se faire à partir d'un ensemble de données qui soit aussi exhaustif que possible, tout en évitant les redondances qui font croître inutilement la base d'apprentissage.

Les étapes (a) à (f) qu'on vient de décrire sont mises en œuvre par le dispositif d'estimation embarqué DESoC, et plus particulièrement son processeur PRE, qui est programmé ou configuré de manière opportune ; l'étape (f), cependant, nécessite également l'intervention de la liaison de données LD et, le cas échéant, du processeur distant PRD, pour stocker les séries temporelles de données sélectionnées dans la base de données BD. Ces étapes, en outre - ou au moins les étapes (a) à (d) - sont mises en œuvre en temps réel. Par contre, les étapes (g) et (h), qui seront décrites ci-après, sont mises en œuvre par le dispositif d'apprentissage distant (non embarqué) DAM, et plus particulièrement son processeur PRD, qui est programmé ou configuré de manière opportune, et sans contrainte de temps réel.

L'étape (g) consiste à créer, par apprentissage statistique, un modèle de régression pour un régime de fonctionnement qui en était dépourvu, à partir des données stockées dans la base de données BD ainsi que de mesures de référence. L'étape (h) consiste à réapprendre un modèle de régression à partir de la base d'apprentissage mise à jour par le dispositif d'estimation embarqué DESoC, comme cela a été décrit plus haut. La mise en œuvre des deux étapes est en fait identique ; les deux étapes se différencient seulement en ce que seule l'étape (h) utilise également des séries temporelles de mesures nouvellement acquises par les capteurs embarqués lors de l'étape (f).

L'apprentissage statistique des coefficients d'un modèle de régression de l'état de charge nécessite la connaissance d'un état de charge « de référence ». Comme expliqué plus haut, ce dernier ne peut pas être mesuré directement, mais seulement estimé, notamment par coulométrie, éventuellement améliorée par la prise en compte d'autres paramètres que le courant électrique.

$$SoC(t) = SoC_0 + \frac{1}{C_{max}} \int_{t_0}^{t} \eta \cdot I(\tau) d\tau \qquad (3)$$

L'état de charge initial $SoC_0$ peut être connu, si la batterie est complètement déchargée ($SoC_0=0$) ou complètement chargée ($SoC_0=100\%$), ou alors être déterminé directement à partir de la tension à vide $U_0$, cette dernière étant mesurée par le capteur de tension CU lorsque la batterie est restée au repos pendant un temps suffisant. Cela signifie qu'une estimation coulométrique fiable de l'état de charge ne peut pas être réalisée en temps réel. En revanche, des techniques « de dilatation » connues permettent au processeur distant PRD de corriger hors ligne (en temps différés) des estimateurs coulométrique du SoC calculés à partir des mesures de courant effectuées par le capteur embarqué CI. Cette correction utilise des mesures de tension à vide. Il s'agit de considérer une série temporelle des estimateurs coulométriques du SoC, bornée par deux instants correspondants aux instants de mesure de tension à vide. Ces deux mesures permettent d'obtenir deux valeurs fiables du SoC et de recaler ladite série temporelle de valeurs du SoC par une des techniques existantes de dilatation (par exemple, cf l'article « A flexible sampling-rate conversion method » de J.O. Smith et P. Gossett, IEEE 1984). Cette amélioration de l'estimation du SoC coulométrique n'est possible que hors ligne. D'autres techniques de calcul amélioré d'un estimateur coulométrique sont envisageables. Les modèles de régression sont utilisés en temps réel par le processeur embarqué PRE, mais ils n'utilisent pas directement l'estimation coulométrique.

Avant de procéder à l'apprentissage des modèles, les données (séries temporelles de mesures) stockées dans la base de données sont filtrées ou lissées comme cela a été décrit plus haut en référence à l'étape d'estimation en temps réel de l'état de charge. Les paramètres du filtre passe-bas ou de lissage peuvent être déterminés de manière automatique, par essais. Il convient de noter que la base de données doit stocker - au moins dans un premier temps - les séries temporelles de mesures à l'état brut (avant filtrage ou lissage) pour permettre le calcul hors ligne des estimateurs coulométriques.

Avant de procéder à l'apprentissage des modèles, il est également avantageux de procéder à une réduction du volume de données d'apprentissage par sous-échantillonnage. En effet, comme cela a été mentionné plus haut, les algorithmes d'apprentissage ne fonctionnent pas bien en présence de volumes de données d'apprentissage trop importants.

Le sous-échantillonnage peut être réalisé, par exemple, en segmentant chaque série temporelle grâce à l'algorithme de la fenêtre glissante (E. Keogh et al. « An Online algorithm for Segmenting Time Series », Proceeding of the IEEE International Conférence on Data Mining ICDM 2001, pages 289-296) et en ne conservant que les points d'extrémité des segments ainsi identifiés. On remarque que le filtrage est généralement un préalable nécessaire au sous-échantillonnage, car des données trop bruitées ne peuvent pas être sous-échantillonnées efficacement. Comme indiqué sur la figure 2, une fois que les estimateurs coulométriques ont été calculés, les données brutes stockées dans la base de données BD peuvent être remplacées par leurs versions filtrées ou lissées et sous-échantillonnées.

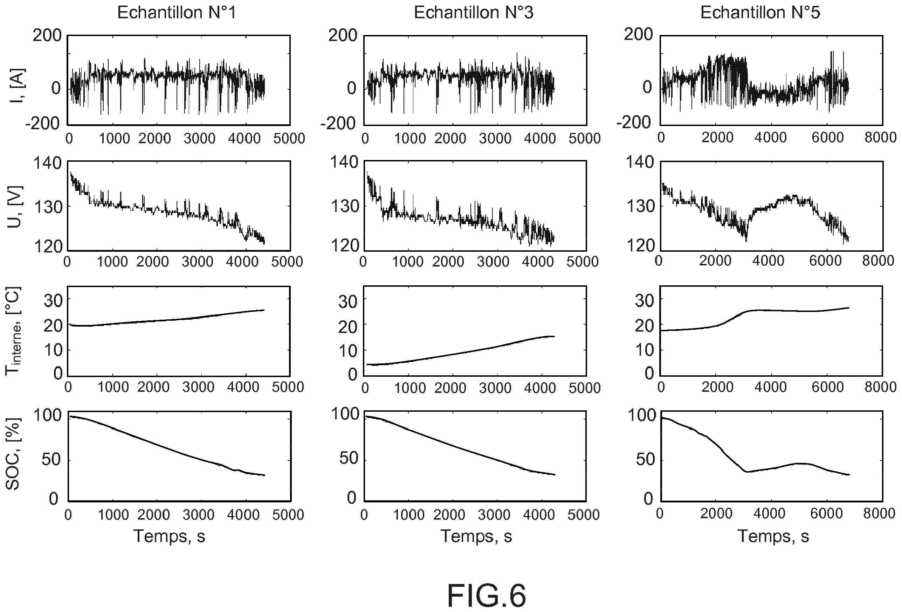

Pour donner un exemple, la performance des techniques de filtrage/lissage et de sous-échantillonnage, un véhicule électrique a effectué six roulages, d'une durée comprise entre 50' et 90' environ, au cours desquels des mesures de courant, tension et température interne ont été acquis à une cadence de 10 Hz (les mesures correspondant au 1$^{er}$, au 3$^e$ et au 5$^e$ roulage, ainsi que les estimations du SoC correspondantes, sont illustrées sur la figure 6). Un filtrage (filtre médian avec une fenêtre glissante de h=15 échantillons, correspondant à 1,5 secondes) et un sous-échantillonnage ont permis de réduire la taille de chaque série temporelle de mesures d'environ 90% (voire de l'ordre de 94% pour les deux derniers roulages, plus longs et comportant donc davantage d'échantillons). L'ensemble des résultats est reproduit dans le tableau ci-dessus. On peut vérifier que l'erreur d'approximation du courant reste très faible. L'erreur d'approximation est définie comme étant la valeur absolue moyenne de la différence entre le signal initial et le signal filtré et sous-échantillonné (sur-échantillonné pour que sa longueur soit égale à celle du signal initial), plus ou moins l'écart type de cette différence.

| Numéro de l'échantillon | 1 | 2 | 3 | 4 | 5 | 6 |
|---|---|---|---|---|---|---|
| Erreur d'approximation après le filtrage/ sous-échantillonnage du signal de courant, [A] | 0,83 ± 0,64 | 0,84 ± 0.62 | 0,83 ± 0.64 | 0,83 ± 0.63 | 2,18 ± 1.53 | 2,19 ± 1.53 |
| Taille de l'échantillon filtré/ initial | 2391/29950 | 2274/35606 | 2229/28996 | 2691/35913 | 2930/52070 | 2755/51538 |

Une réduction de la taille de la base de données d'apprentissage peut également être obtenue en supprimant des séries temporelles de mesures devenues obsolètes. Pour cela, on peut surveiller - en temps réel ou de manière discontinue - l'état de santé de la batterie (de nombreuses techniques connues de l'art antérieur permettent de le faire, par exemple à partir de mesures semblables à celles utilisées pour l'estimation de l'état de charge - voir par exemple les documents US6411911 et US8269502). Les données stockées dans la base de données peuvent alors être « étiquetées » avec une indication d'état de santé correspondant. En cas de dégradation de l'état de santé de la batterie, les données associées à un état de santé trop différent (différence supérieure à un seuil déterminé) à l'état de santé courant peuvent être considérées comme obsolètes et supprimées.

Ensuite, le processeur distant PRD procède à l'apprentissage - ou au réapprentissage - d'un ou plusieurs modèles de régression à partir des mesures stockées dans la base de données - filtrées, sous-échantillonnées et expurgées des données obsolètes (à ce stade, la structure temporelle des mesures n'est plus prise en compte : les « séries temporelles » deviennent des simples ensembles de mesures instantanées). Puis, les coefficients caractérisant ledit ou chaque dit modèle sont transmis, par l'intermédiaire de la liaison de données LD, au dispositif d'estimation embarqué DESoC qui les utilise, comme décrit en précédence, pour l'estimation en temps réel de l'état de charge SoC de la batterie.

L'apprentissage ou réapprentissage d'un modèle comprend plusieurs opérations : la présélection d'une base d'apprentissage, la normalisation des données sélectionnées, puis l'apprentissage proprement dit

La présélection consiste à choisir uniquement les données (mesures) associées au régime de fonctionnement (caractérisé, par exemple, par une plage de valeurs de l'état de charge) de la batterie pour lequel ledit modèle doit être utilisé. Par contre, les données choisies peuvent correspondre à des conditions d'utilisation différentes (caractérisées, par exemple, par des températures et/ou des intensités de courant différentes).

Les données sélectionnées pour constituer la base d'apprentissage sont normalisées. Seules les mesures instantanées - destinées à servir de variables explicatives du modèle de régression - sont normalisées, tandis que les états de charge de référence, estimés par coulométrie améliorée (équation 3) ne le sont pas. La normalisation d'une variable s'effectue généralement en la centrant par rapport à sa moyenne et en la divisant par son écart-type. Ici, la moyenne et l'écart type de chaque variable explicative sont calculés sur toute la base d'apprentissage ; comme cette dernière évolue dans le temps, la normalisation doit être effectuée à chaque fois qu'on apprend le modèle.

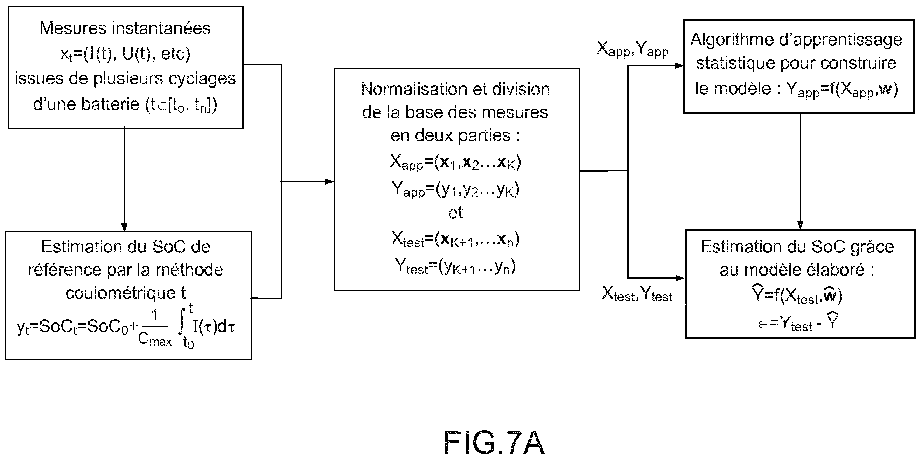

La base d'apprentissage présélectionnée et normalisée sert ensuite à estimer les coefficients du modèle de régression non-linéaire (équation 2). Ce modèle contient, à part les coefficients de régression **w** à estimer, des paramètres

λ à calibrer. Suivant la méthode d'apprentissage choisie (plusieurs d'entre elles sont connues) le nombre de ces paramètres à calibrer varie. Les meilleures valeurs de ces paramètres peuvent être obtenues automatiquement par une approche dite de validation croisée, dont le principe général est illustré par la figure 7A. Cette figure montre qu'un ensemble de données sélectionnées pour apprentissage et normalisées est divisé en deux parties : un sous-ensemble « d'apprentissage » {**X$_{app}$**, **Y$_{app}$**} et un sous-ensemble « de test» {**X$_{test}$**, **Y$_{test}$**}. Dans chaque paire {**X,Y**}, X désigne une matrice dont les colonnes correspondent aux grandeurs mesurées (courant, tension, température ...) et les lignes aux instants de mesure. A chaque ligne de X est associée une valeur de référence de l'état de charge $y_t$ estimée par la méthode de coulométrie améliorée. Les données {**X$_{app}$**, **Y$_{app}$**} sont ensuite divisées en V parties. Un algorithme de V itérations est ensuite exécuté. A chaque itération i, {V\i} parties sont utilisées pour estimer les coefficients de régression **w** (on indique ces estimations par **$\hat{w}$**) et la i-ème partie, dite de validation, est utilisées pour estimer l'erreur $\varepsilon_i$ = **Y$_{test}$**-$\hat{\textbf{Y}}$

où $\hat{\textbf{Y}}$=f$_\lambda$(**X$_{test}$**, **$\hat{w}$**). L'erreur moyenne $\bar{\epsilon} = 1/V \sum_{i=1}^{V} \epsilon_i$ fournit une indication sur la bonté du modèle. Cet algorithme à V itérations est répété pour plusieurs valeurs du vecteur des paramètres λ. Le meilleur vecteur λ est celui qui correspond au plus petit $\bar{\varepsilon}$. Si V est égale aux nombres d'individus dans la base d'apprentissage, alors ce type de validation croisée est appelé « leave-one-out » («exclut-en un »). Si l'ensemble d'apprentissage est divisé en V parties distinctes, il s'agit de la technique dite « V-fold ». Si ces parties ne sont pas distinctes, c'est-à-dire le même individu se trouve dans plusieurs parties à la fois et certains individus n'apparaissent dans aucune des parties, alors on parle de « sous-échantillonnage aléatoire avec remise ».

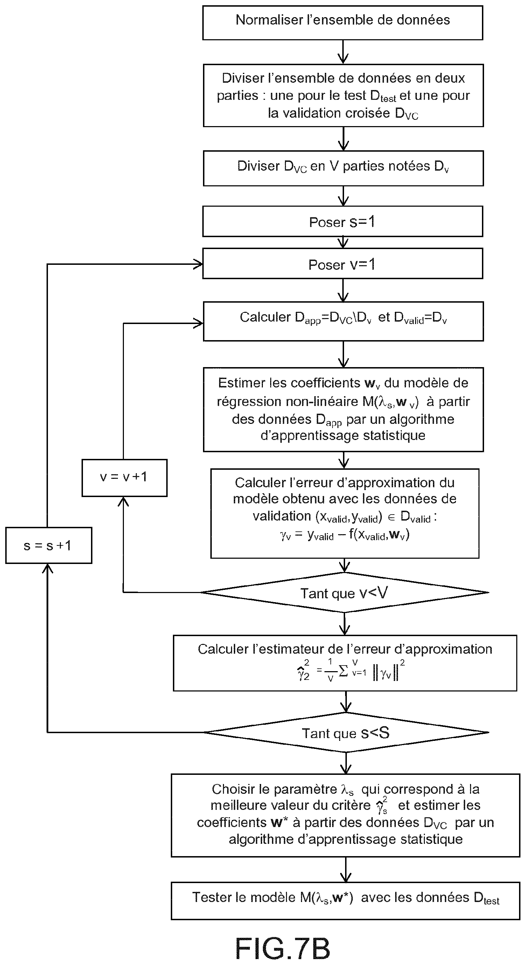

La figure 7B illustre plus en détail un algorithme du type « V-fold ».

Un procédé selon l'invention peut utiliser plusieurs techniques d'apprentissage statistique : réseau de neurones, SVR, RVM, régression « ridge » à noyaux, forêts aléatoires, etc... Une technique particulièrement utile est celle dite « Machine à Vecteurs Pertinents » (RVM), décrite dans l'article de M.E. Tipping « Sparse Bayesian Learning and the Relevance Vector Machine» Journal of Machine Learning Research 1: 211-244 (2001).

Soient $x \in \mathbb{R}^p$ un vecteur composé de p mesures telles que le courant, la tension, la température interne de la batterie, la température externe, etc, $\mathcal{X}_M = \{x_1, x_2, \ldots, x_M\}$ un ensemble de vecteurs représentant des mesures prises dans le passé et

$$\mathcal{Y}_M = \{SoC_1, SoC_2, \ldots, SoC_M\}$$

un ensemble des valeurs d'état de charge obtenues par la méthode coulométrique améliorée. Étant donné des ensembles $\mathcal{X}_M$ et $\mathcal{Y}_M$, l'algorithme RVM cherche à estimer les coefficients de régression w$_j$ tels que :

$$SoC_i = \sum_{j=1}^{M} w_0 + w_j K(x_j, x_i) + \varepsilon_i, \forall i = 1, \ldots, M \qquad (4)$$

où chaque élément de la matrice K est un noyau Gaussien $K(x, y) = e^{\frac{-\|x-y\|^2}{2\sigma^2}}$ avec le paramètre σ estimé par une méthode de validation croisée décrite ci-dessus. Pour que le modèle de régression non-linéaire (équation 4) soit lisse et simple, pour éviter ainsi le surapprentissage et diminuer la complexité du modèle, l'algorithme RVM fournit une solution régularisée ce qui a pour conséquence l'annulation d'un certain nombre de coefficients de régression w$_j$. Les vecteurs x$_j$ qui correspondent aux coefficients de régression non-nuls w$_j$ sont appelés les vecteurs-support. Le modèle obtenu est ensuite appliqué pour estimer l'état de charge de la batterie à l'instant t :

$$SoC_t = w_0 + \sum_{\forall j \text{ t.q.} w_j \neq 0} w_j K(x_j, x_t) \qquad (5)$$

On remarque que, pour pouvoir appliquer l'équation 5 ci-dessus, tant les coefficients de régression w$_0$ et w$_j$ que les vecteurs-supports x$_j$ doivent être stockés dans la mémoire ME. En d'autres termes, les vecteurs-supports x$_j$ et les coefficients de régression w$_j$ constituent des « coefficients » du modèle d'estimation de SoC.

L'invention a été décrite en référence à un cas particulier dans lequel la batterie est la batterie d'un véhicule automobile électrique ou hybride, mais il ne s'agit pas d'une limitation essentielle. L'invention peut en effet s'appliquer à tout type de batterie, pour l'alimentation de tout type d'appareil ou dispositif consommateur d'énergie.

**Revendications**

1.  Procédé d'estimation de l'état de charge d'une batterie (BATT) comprenant les étapes suivantes :

    a) acquérir au moins une série temporelle de mesures de tension ($U_\tau$) aux bornes de ladite batterie, ainsi qu'au moins une autre série temporelle de mesures d'un autre paramètre physique de ladite batterie ou de son environnement ;
    b) en fonction desdites mesures, déterminer un régime de fonctionnement de ladite batterie ;

    **caractérisé en ce que** le procédé comprend en outre les étapes suivantes :

    c) en fonction dudit régime de fonctionnement, choisir un modèle de régression non-linéaire parmi un ensemble prédéfini de tels modèles ; et
    d) estimer l'état de charge (SoC) de ladite batterie par application dudit modèle de régression non-linéaire à ladite série temporelle de mesures de tension et à ladite ou à au moins une dite autre série temporelle de mesures.

2.  Procédé selon la revendication 1 dans lequel ledit ou les autres dits paramètres physiques sont choisis parmi : un courant ($I_\tau$) fourni ou absorbé par la batterie, une température interne ($T_\tau$) de la batterie, une température ambiante ($T_{ext,\tau}$), une moyenne de valeurs de ladite série temporelle de mesures de tension, le fait que la batterie soit en cours de chargement ou de déchargement, une vitesse de chargement ou de déchargement, une impédance de la batterie ou une mesure de son état de santé.

3.  Procédé selon l'une des revendications précédentes dans lequel ladite étape a) comprend au moins l'acquisition d'une série temporelle de mesures de tension ($U_\tau$) aux bornes de ladite batterie et d'une série temporelle de mesures de courant ($I_\tau$) fourni ou absorbé par la batterie ; et dans lequel ladite étape b) comprend la détermination d'une estimation dudit régime de fonctionnement à partir d'au moins une valeur de tension et une valeur de courant issues desdites séries temporelles de mesures.

4.  Procédé selon la revendication 3 dans lequel ladite étape b) comprend la détermination de ladite estimation dudit régime de fonctionnement de ladite batterie à partir d'une valeur moyenne de tension à ses bornes et d'une valeur moyenne de courant absorbé ou fourni par la batterie au moyen d'un tableau ou fonction de correspondance.

5.  Procédé selon l'une des revendications 3 ou 4 dans lequel ladite étape c) comprend le choix d'un modèle, également en fonction dudit ou d'un dit autre paramètre physique ou d'une information d'état de santé de ladite batterie.

6.  Procédé selon l'une des revendications précédentes comprenant une opération de filtrage passe-bas ou lissage de ladite ou d'au moins une dite série temporelle de mesures préalablement à ladite étape d).

7.  Procédé selon l'une des revendications précédentes dans lequel ledit ensemble prédéfini de modèles de régression non-linéaire comprend une pluralité de modèles dont au moins un choisi parmi un modèle de régression à noyaux, un modèle de régression à vecteurs de support et une machine à vecteurs pertinents.

8.  Procédé selon l'une des revendications précédentes comprenant également les étapes suivantes :

    e) déterminer si lesdites séries temporelles de mesures correspondent à des conditions d'utilisation qui n'ont pas été prises en compte lors de la construction des modèles de régression non-linéaire dudit ensemble, une condition d'utilisation étant définie par un ou plusieurs paramètres de la batterie ou de son environnement ; et
    f) dans l'affirmative, stocker ladite ou lesdites séries temporelles de mesures dans une base de données (BD).

9.  Procédé selon la revendication 8 dans lequel ladite étape f) comprend également la détermination d'une information relative à un état de charge de ladite batterie et l'association de ladite information à ladite ou à chaque dite série temporelle de mesures, le procédé comprenant également une opération d'exclusion de ladite base de données d'au moins une série temporelle de mesures sur la base d'une comparaison entre l'information d'état de charge qui lui est associée et une information d'état de charge de la batterie déterminée ultérieurement.

10. Procédé selon l'une des revendications précédentes comprenant également l'étape suivante :
    g) construire les modèles de régression non-linéaire dudit ensemble par apprentissage à partir au moins d'une pluralité de séries temporelles de mesures de tension aux bornes de ladite batterie et d'au moins une autre série temporelle de mesures d'un autre paramètre physique de ladite batterie ou de son environnement, et de valeurs de référence correspondants de l'état de charge de ladite batterie.

**11.** Procédé selon la revendication 10 lorsqu'elle dépend de l'une des revendications 8 ou 9, comportant également l'étape suivante :

h) reconstruire par apprentissage lesdits ou au moins un dit modèle de régression non-linéaire, ou construire par apprentissage un nouveau modèle de régression non-linéaire dudit ensemble, en tenant compte de la ou des séries temporelles stockées dans ladite base de données lors de ladite étape f).

**12.** Procédé selon l'une des revendications 10 ou 11 dans lequel ladite étape g) et/ou ladite étape h) comprend des opérations préalables de filtrage passe-bas ou lissage et de sous-échantillonnage desdites séries temporelles de mesures.

**13.** Procédé selon l'une des revendications 10 à 12 dans lequel ladite étape g) et/ou ladite étape h) comprennent le calcul en temps différé d'estimateurs coulométriques de la charge de ladite batterie à partir de séries temporelles de mesures de courant acquises lors de ladite étape a), et l'utilisation desdits estimateurs coulométriques en tant que valeurs de référence de l'état de charge de ladite batterie pour la construction ou reconstruction par apprentissage desdits modèles de régression non-linéaire.

**14.** Procédé selon l'une des revendications précédentes dans lequel ladite batterie est intégrée à un dispositif consommateur d'énergie, et dans lequel lesdites étapes a) à d) ou a) à f) sont mises en œuvre en temps réel par un dispositif (DESoC) d'estimation d'état de charge également intégré audit dispositif consommateur d'énergie.

**15.** Procédé selon la revendication 14 lorsqu'elle dépend de l'une des revendications 10 à 12, dans lequel ladite étape g) ou lesdites étapes g) et h) sont mises en œuvre en temps différé par un dispositif d'apprentissage de régression (PRD) non intégré audit dispositif consommateur d'énergie.

**16.** Dispositif d'estimation d'état de charge (DESoC) d'une batterie (BATT) comportant :

- au moins un capteur de tension (CV), pour mesurer une tension aux bornes de ladite batterie ;
- au moins un autre capteur (CT1, CT1, CI), pour mesurer un autre paramètre physique de ladite batterie ou de son environnement ;
**caractérisé par**
- une mémoire (ME) pour stocker un ensemble de modèles de régression non-linéaire de l'état de charge de ladite batterie ; et
- un processeur (PRE) programmé ou configuré pour mettre en œuvre les étapes d'un procédé selon l'une des revendications 1 à 9 en coopérant avec lesdits capteurs et ladite mémoire.

**17.** Dispositif d'apprentissage de modèles de régression (DAM) comprenant :

- une base de données stockant une pluralité de séries temporelles de mesures de tension aux bornes d'une batterie, ainsi que d'au moins un autre paramètre physique de ladite batterie ou de son environnement ; **caractérisé par**
- un processeur (PRD) programmé ou configuré pour construire une pluralité de modèles de régression non-linéaires de la tension aux bornes de ladite batterie pour des régimes de fonctionnement de ladite batterie par apprentissage à partir au moins d'une pluralité de séries temporelles de mesures de tension aux bornes de ladite batterie et d'au moins une autre série temporelle de mesures d'un autre paramètre physique de la batterie ou de son environnement, et de valeurs de référence correspondants de l'état de charge de ladite batterie.

**18.** Système d'estimation de l'état de charge d'une batterie comprenant un dispositif d'estimation d'état de charge (DESoC) selon la revendication 16, un dispositif d'apprentissage de modèles de régression (DAM) selon la revendication 17 et un système de transmission de données (LD) reliant lesdits dispositifs.

**Patentansprüche**

**1.** Verfahren zum Schätzen des Ladezustandes eines Akkumulators (BATT), folgende Schritte umfassend:

a) Erfassen mindestens einer zeitlichen Serie von Spannungsmessungen ($U_\tau$) an den Klemmen des Akkumulators, sowie mindestens einer anderen zeitlichen Serie von Messungen eines anderen physischen Parameters des Akkumulators oder seiner Umgebung;

b) angesichts der Messungen, Bestimmen eines Betriebszustandes des Akkumulators;

**dadurch gekennzeichnet, dass** das Verfahren zudem folgende Schritte umfasst:

c) angesichts des Betriebszustandes, wählen eines nichtlinearen Regressionsmodells aus einer vorbestimmten Gruppe solcher Modelle; und

d) Schätzen des Ladezustandes (SoC) des Akkumulators durch Anwendung des nichtlinearen Regressionsmodells auf die zeitliche Serie von Spannungsmessungen und auf die oder auf die mindestens eine andere zeitliche Serie von Messungen.

2. Verfahren nach Anspruch 1, bei welchem der oder die anderen physischen Parameter gewählt sind aus: einem Strom ($I_\tau$), welcher durch den Akkumulator geliefert oder absorbiert wird, einer Innentemperatur ($T_\tau$) des Akkumulators, einer Umgebungstemperatur ($T_{ext,\tau}$), einem Mittelwert der zeitlichen Serie von Spannungsmessungen, der Tatsache, dass der Akkumulator augenblicklich geladen oder entladen wird, einer Lade- oder Entladegeschwindigkeit, einer Impedanz des Akkumulators oder einer Messung seines Gesundheitszustandes.

3. Verfahren nach einem der vorhergehenden Ansprüche, bei welchem der Schritt a) mindestens die Erfassung einer zeitlichen Serie von Spannungsmessungen ($U_\tau$) an den Klemmen des Akkumulators und einer zeitlichen Serie von Strommessungen ($I_\tau$) von durch den Akkumulator geliefertem oder absorbiertem Strom umfasst; und bei welchem der Schritt b) die Bestimmung einer Schätzung des Betriebszustandes anhand mindestens eines Spannungswertes und eines Stromwertes umfasst, welche aus den zeitlichen Serien von Messungen stammen.

4. Verfahren nach Anspruch 3, bei welchem der Schritt b) die Bestimmung der Schätzung des Betriebszustandes des Akkumulators anhand eines Mittelwertes der Spannung an seinen Klemmen und eines Mittelwertes des durch den Akkumulator absorbierten oder gelieferten Stroms mithilfe einer Entsprechungstabelle oder -funktion umfasst.

5. Verfahren nach einem der Ansprüche 3 oder 4, bei welchem der Schritt c) die Wahl eines Modells, ebenfalls angesichts des oder des einen anderen physischen Parameters oder einer Information über den Gesundheitszustand des Akkumulators umfasst.

6. Verfahren nach einem der vorhergehenden Ansprüche, umfassend einen Schritt des Tiefpassfilterns oder des Glättens der oder der mindestens einen zeitlichen Serie von Messungen vor Schritt d).

7. Verfahren nach einem der vorhergehenden Ansprüche, bei welchem die vorbestimmte Gruppe von nichtlinearen Regressionsmodellen eine Vielzahl von Modellen umfasst, darunter mindestens eines, gewählt aus einem Kernregressions-Modell, einem Regressionsmodell mit Stützvektoren und einer Relevanzvektor-Maschine.

8. Verfahren nach einem der vorhergehenden Ansprüche, welches zudem folgende Schritte umfasst:

e) Bestimmen, ob die zeitlichen Serien von Messungen Gebrauchsbedingungen entsprechen, die nicht bei der Konstruktion der nichtlinearen Regressionsmodelle der Gruppe berücksichtigt worden sind, wobei eine Gebrauchsbedingung durch einen oder mehrere Parameter des Akkumulators oder seiner Umgebung definiert ist; und

f) wenn ja, Speichern der zeitlichen Serie(n) von Messungen in einer Datenbank (BD).

9. Verfahren nach Anspruch 8, bei welchem der Schritt f) ebenfalls die Bestimmung einer Information zu einem Ladezustand des Akkumulators und die Zuordnung der Information mit der oder einer jeden zeitlichen Serie von Messungen umfasst, wobei das Verfahren ebenfalls einen Schritt des Ausschlusses aus der Datenbank mindestens einer zeitlichen Serie von Messungen umfasst, auf der Grundlage eines Vergleichs zwischen der Information zum Ladezustand, die ihr zugeordnet ist, und einer Information zum Ladezustand des Akkumulators, welche zu einem späteren Zeitpunkt bestimmt wird.

10. Verfahren nach einem der vorhergehenden Ansprüche, welches zudem folgenden Schritt umfasst:
g) Konstruieren der nichtlinearen Regressionsmodelle der Gruppe durch Lernen anhand mindestens einer Vielzahl von zeitlichen Serien von Spannungsmessungen an den Klemmen des Akkumulators und anhand mindestens einer anderen zeitlichen Serie von Messungen eines anderen physischen Parameters des Akkumulators oder seiner Umgebung, und von entsprechenden Referenzwerten des Ladezustands des Akkumulators entsprechen.

11. Verfahren nach Anspruch 10 in Abhängigkeit von einem der Ansprüche 8 oder 9, welches ebenfalls folgenden Schritt umfasst

h) Rekonstruieren durch Lernen der oder des mindestens einen nichtlinearen Regressionsmodelle/Regressionsmodells, oder Konstruieren durch Lernen eines neuen nichtlinearen Regressionsmodells der Gruppe, unter Berücksichtigung der im Schritt f) in der Datenbank gespeicherten zeitlichen Serie(n).

12. Verfahren nach einem der Ansprüche 10 oder 11, bei welchem der Schritt g) und/oder der Schritt h) vorherige Schritte des Tiefpassfilterns oder des Glättens der und des Unterabtastens der zeitlichen Serien von Messungen umfasst.

13. Verfahren nach einem der Ansprüche 10 bis 12, bei welchem der Schritt g) und/oder der Schritt h) die zeitversetzte Berechnung von coulometrischen Schätzfunktionen der Ladung des Akkumulators anhand von zeitlichen Strommessserien, welche im Schritt a) erfasst wurden, und die Verwendung der coulometrischen Schätzfunktionen als Referenzwerte des Ladezustands des Akkumulators für die Konstruktion oder Rekonstruktion durch Lernen der nichtlinearen Regressionsmodelle umfasst.

14. Verfahren nach einem der vorhergehenden Ansprüche, bei welchem der Akkumulator in eine Energie verbrauchende Vorrichtung integriert ist, und bei welchem die Schritte a) bis d) oder a) bis f) in Echtzeit durch eine Vorrichtung (DESoC) zum Schätzen des Ladezustandes umgesetzt werden, welche ebenfalls in die Energie verbrauchende Vorrichtung integriert ist.

15. Verfahren nach Anspruch 14 in Abhängigkeit von einem der Ansprüche 10 bis 12, bei welchem der Schritt g) oder die Schritte g) und h) zeitversetzt durch eine Vorrichtung zum Lernen von Regression (PRD) umgesetzt wird/werden, welche nicht in die Energie verbrauchende Vorrichtung integriert ist.

16. Vorrichtung zum Schätzen eines Ladezustandes (DESoC) eines Akkumulators (BATT), Folgendes umfassend:

- mindestens einen Spannungssensor (CV) zum Messen einer Spannung an den Klemmen des Akkumulators;
- mindestens einen anderen Sensor (CT1, CT1, CI) zum Messen eines anderen physischen Parameters des Akkumulators oder seiner Umgebung;
**gekennzeichnet durch**
- einen Speicher (ME) zum Speichern einer Gruppe von nichtlinearen Regressionsmodellen des Ladezustandes des Akkumulators; und
- einen Prozessor (PRE), welcher programmiert oder konfiguriert ist, um die Schritte eines Verfahrens nach einem der Ansprüche 1 bis 9 durch Kooperation mit den Sensoren und dem Speicher umzusetzen.

17. Vorrichtung zum Lernen von Regressionsmodellen (DAM), Folgendes umfassend:

- eine Datenbank, welche eine Vielzahl von zeitlichen Spannungsmessungen an den Klemmen eines Akkumulators speichert, sowie mindestens einen anderen physischen Parameter des Akkumulators oder seiner Umgebung;
**gekennzeichnet durch**
- einen Prozessor (PRD), welcher zum Konstruieren einer Vielzahl von nichtlinearen Regressionsmodellen der Spannung an den Klemmen des Akkumulators für Betriebszustände des Akkumulators durch Lernen anhand mindestens einer Vielzahl von zeitlichen Serien von Spannungsmessungen an den Klemmen des Akkumulators und anhand mindestens einer anderen zeitlichen Serie von Messungen eines anderen physischen Parameters des Akkumulators oder seiner Umgebung, und von entsprechenden Referenzwerten des Ladezustands des Akkumulators, programmiert oder konfiguriert ist.

18. System zum Schätzen des Ladezustandes eines Akkumulators, umfassend eine Vorrichtung zum Schätzen des Ladezustandes (DESoC) nach Anspruch 16, eine Vorrichtung zum Lernen von Regressionsmodellen (DAM) nach Anspruch 17 und ein die Vorrichtungen verbindendes Datenübertragungssystem (LD).

**Claims**

1. A method for estimating the state of charge of a battery (BATT) comprising the following steps:

   a) acquiring at least one time series of measurements of voltage ($U_\tau$) across the terminals of said battery, as well as at least one other time series of measurements of another physical parameter of said battery or of its environment;
   b) determining, as a function of said measurements, an operating regime of said battery;

   **characterized in that**, the method further comprises the following steps:

   c) choosing, as a function of said operating regime, a non-linear regression model from among a predefined set of such models; and
   d) estimating the state of charge (SoC) of said battery by applying said non-linear regression model to said time series of voltage measurements and to said or to at least one said other time series of measurements.

2. The method of claim 1, in which the one said or the other said physical parameters are chosen from among: a current ($I_\tau$) provided or absorbed by the battery, an internal temperature ($T_\tau$) of the battery, an ambient temperature ($T_{ext,\tau}$), a mean of values of said time series of voltage measurements, the fact that the battery is undergoing charging or discharging, a charging or discharging rate, an impedance of the battery or a measurement of its state of health.

3. The method of any of the preceding claims, in which said step a) comprises at least the acquisition of a time series of measurements of voltage ($U_\tau$) across the terminals of said battery and of a time series of measurements of current ($I_\tau$) provided or absorbed by the battery; and in which said step b) comprises the determination of an estimate of said operating regime on the basis of at least one voltage value and one current value arising from said time series of measurements.

4. The method of claim 3, in which said step b) comprises the determination of said estimate of said operating regime of said battery on the basis of a mean value of voltage across its terminals and of a mean value of current absorbed or provided by the battery by means of a correspondence table or function.

5. The method of any of claims 3 or 4, in which said step c) comprises the choosing of a model, also as a function of said or of one said other physical parameter or of an item of information regarding a state of health of said battery.

6. The method of any of the preceding claims, comprising an operation of low-pass filtering or smoothing of said or of at least one said time series of measurements prior to said step d).

7. The method of any of the preceding claims, in which said predefined set of non-linear regression models comprises a plurality of models at least one of which is chosen from among a kernel regression model, a support vector regression model and a relevance vector machine.

8. The method of any of the preceding claims, also comprising the following steps:

   e) determining whether said time series of measurements correspond to conditions of use which have not been taken into account during the construction of the non-linear regression models of said set, a condition of use being defined by one or more parameters of the battery or of its environment; and
   f) in the affirmative, storing said one or more time series of measurements in a database (BD).

9. The method of claim 8, in which said step f) also comprises the determination of an item of information relating to a state of charge of said battery and the association of said item of information with said or with each said time series of measurements, the method also comprising an operation of excluding from said database at least one time series of measurements on the basis of a comparison between the state of charge item of information which is associated therewith and an item of information regarding state of charge of the battery determined subsequently.

10. The method of any of the preceding claims, also comprising the following step:
   g) constructing the non-linear regression models of said set by training on the basis at least of a plurality of time series of measurements of voltage across the terminals of said battery and of at least one other time series of measurements of another physical parameter of said battery or of its environment, and of corresponding reference values of the state of charge of said battery.

11. The method of claim 10 when it depends on one of claims 8 or 9, also comprising the following step:
h) reconstructing by training the said or at least one said non-linear regression model, or constructing by training a new non-linear regression model of said set, by taking account of the one or more time series stored in said database during said step f).

12. The method of any of claims 10 or 11, in which said step g) and/or said step h) comprises prior operations of low-pass filtering or smoothing and of sub-sampling of said time series of measurements.

13. The method of any of claims 10 to 12, in which said step g) and/or said step h) comprise the calculation in non-real time of coulometric estimators of the charge of said battery on the basis of time series of measurements of current acquired during said step a), and the use of said coulometric estimators as reference values of the state of charge of said battery for the construction or reconstruction by training of said non-linear regression models.

14. The method of any of the preceding claims, in which said battery is integrated into an energy-consuming device, and in which said steps a) to d) or a) to f) are implemented in real time by a state-of-charge estimation device (DESoC) also integrated into said energy-consuming device.

15. The method of claim 14 when it depends on one of claims 10 to 12, in which said step g) or said steps g) and h) are implemented in non-real time by a regression training device (PRD) not integrated into said energy-consuming device.

16. A device for estimating state of charge (DESoC) of a battery (BATT) comprising:

- at least one voltage sensor (CV), for measuring a voltage across the terminals of said battery;
- at least one other sensor (CT1, CT1, CI), for measuring another physical parameter of said battery or of its environment;
**characterized by**,
- a memory (ME) for storing a set of non-linear regression models of the state of charge of said battery; and
- a processor (PRE) programmed or configured to implement the steps of a method of any one of claims 1 to 9 by cooperating with said sensors and said memory.

17. A device for training regression models (DAM) comprising:

- a database storing a plurality of time series of measurements of voltage across the terminals of a battery, as well as at least one other physical parameter of said battery or of its environment;

**characterized by**:

- a processor (PRD) programmed or configured to construct a plurality of non-linear regression models of voltage across the terminals of said battery for operating regimes of said battery by training from at least a plurality of time series of measurements of voltage across the terminals of said battery and at least one other time series of measurements of another physical parameter of the battery or of its environment and of corresponding reference values of the state of charge of said battery.

18. A system for estimating the state of charge of a battery comprising a state-of-charge estimation device (DESoC) of claim 16, a device for training regression models (DAM) of claim 17 and a data transmission system (LD) linking said devices.

FIG.1

FIG.4

FIG.2

FIG.3A

FIG.3B

Des mesures prises durant les h derniers instants :
$U_\tau$, $I_\tau$, $T_\tau$, $T_{ext,\tau}$ , $\forall \tau$ = t-h,...,t

↓

Calculer la température externe moyenne $\overline{T}_{ext}$

↓

Si aucun sous-
ensemble de la BD ne
correspond à $\overline{T}_{ext}$ — **Oui** →

↓ **Non**

Identifier le régime de charge ou de
décharge de batterie

↓

Si aucun sous-ensemble
de la BD ne correspond
au régime en cours — **Oui** →

↓ **Non**

Identifier l'intervalle dans lequel se trouve la valeur
de SoC grâce à la mesure de tension $U_t$

↓

Si aucun sous-ensemble
de la BD ne correspond à
la tension en cours — **Oui** →

↓ **Non**

Ne pas sauvegarder de
donnée, ne pas
réapprendre de modèle

Sauvegarder des
nouvelles données et
réapprendre les
modèles

# FIG.5

FIG.6

```
┌────────────────────────────┐
│   Mesures instantanées      │
│   x_t=(I(t), U(t), etc)     │
│  issues de plusieurs cyclages│
│   d'une batterie (t∈[t_o, t_n])│
└────────────────────────────┘
```

$x_t = (I(t),\ U(t),\ etc)$

issues de plusieurs cyclages d'une batterie $(t \in [t_o, t_n])$

Normalisation et division de la base des mesures en deux parties :

$X_{app} = (x_1, x_2 \ldots x_K)$

$Y_{app} = (y_1, y_2 \ldots y_K)$

et

$X_{test} = (x_{K+1}, \ldots x_n)$

$Y_{test} = (y_{K+1} \ldots y_n)$

$X_{app}, Y_{app}$

Algorithme d'apprentissage statistique pour construire le modèle : $Y_{app} = f(X_{app}, \mathbf{w})$

Estimation du SoC de référence par la méthode coulométrique

$$y_t = SoC_t = SoC_0 + \frac{1}{C_{max}} \int_{t_0}^{t} I(\tau) d\tau$$

$X_{test}, Y_{test}$

Estimation du SoC grâce au modèle élaboré :

$$\hat{Y} = f(X_{test}, \hat{\mathbf{w}})$$

$$\in = Y_{test} - \hat{Y}$$

# FIG.7A

Normaliser l'ensemble de données

Diviser l'ensemble de données en deux parties : une pour le test $D_{test}$ et une pour la validation croisée $D_{VC}$

Diviser $D_{VC}$ en V parties notées $D_v$

Poser s=1

Poser v=1

Calculer $D_{app}=D_{VC}\backslash D_v$ et $D_{valid}=D_v$

Estimer les coefficients $\mathbf{w}_v$ du modèle de régression non-linéaire $M(\lambda_s,\mathbf{w}_v)$ à partir des données $D_{app}$ par un algorithme d'apprentissage statistique

v = v +1

Calculer l'erreur d'approximation du modèle obtenu avec les données de validation $(x_{valid},y_{valid}) \in D_{valid}$ :
$$\gamma_v = y_{valid} - f(x_{valid},\mathbf{w}_v)$$

Tant que v<V

s = s +1

Calculer l'estimateur de l'erreur d'approximation
$$\hat{\gamma}_2^2 = \frac{1}{V}\Sigma_{v=1}^{V} \|\gamma_v\|^2$$

Tant que s<S

Choisir le paramètre $\lambda_s$ qui correspond à la meilleure valeur du critère $\hat{\gamma}_s^2$ et estimer les coefficients $\mathbf{w}^*$ à partir des données $D_{VC}$ par un algorithme d'apprentissage statistique

Tester le modèle $M(\lambda_s,\mathbf{w}^*)$ avec les données $D_{test}$

# FIG.7B

## RÉFÉRENCES CITÉES DANS LA DESCRIPTION

**Documents brevets cités dans la description**

- US 4677363 A
- US 20100090651 A
- US 7197487 B
- US 20100324848 A
- US 6411911 B
- US 8269502 B

**Littérature non-brevet citée dans la description**

- **DE S. PILLER ; M. PERRIN ; A. JOSSEN.** Methods for state-of-charge détermination and their applications. *Journal of Power Sources,* 2001, vol. 96, 113-120
- **KONG SOON NG et al.** Enhanced coulomb counting method for estimating state-of-charge and state-of-health of lithium-ion batteries. *Applied Energy,* 2009, vol. 86, 1506-1511
- **T. HANSEN ; CHIA-JIU WANG.** Support vector based state of charge estimator. *Journal of Power Sources,* 2005, vol. 141, 351-358
- **DE J.O. SMITH ; P. GOSSETT.** A flexible sampling-rate conversion method. IEEE, 1984
- **E. KEOGH et al.** An Online algorithm for Segmenting Time Series. *Proceeding of the IEEE International Conférence on Data Mining ICDM,* 2001, 289-296
- **DE M.E. TIPPING.** Sparse Bayesian Learning and the Relevance Vector Machine. *Journal of Machine Learning Research,* 2001, vol. 1, 211-244